(19) Europäisches Patentamt
European Patent Office
Office européen des brevets

(11) **EP 2 763 203 A2**

(12) **DEMANDE DE BREVET EUROPEEN**

(43) Date de publication:
**06.08.2014 Bulletin 2014/32**

(51) Int Cl.:
***H01L 51/46*** *(2006.01)* ***C08G 61/12*** *(2006.01)*

(21) Numéro de dépôt: **13199612.6**

(22) Date de dépôt: **26.12.2013**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **31.01.2013 FR 1350838**

(71) Demandeur: **COMMISSARIAT A L'ENERGIE ATOMIQUE ET AUX ENERGIES ALTERNATIVES**
**75015 Paris (FR)**

(72) Inventeurs:
- **Senghor, Mathieu**
  **73000 CHAMBERY (FR)**
- **Berson, Solenn**
  **73000 CHAMBERY (FR)**
- **Manceau, Matthieu**
  **74000 ANNECY (FR)**

(74) Mandataire: **Cabinet Laurent & Charras**
**Le Contemporain**
**50 Chemin de la Bruyère**
**69574 Dardilly Cedex (FR)**

(54) **Élaboration de dispositifs optoélectroniques, notamment de cellules OPV de type inverse**

(57) Cette élaboration met en oeuvre une composition comprenant :
- du poly(3,4-éthylènedioxythiophène) ou PEDOT ;
- du polystyrènesulfonate ou PSS ;
- un composé (A) de formule :

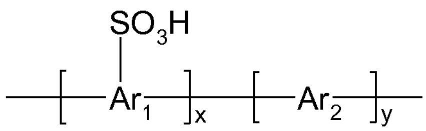

avec
- $0 < x/y < 1$ ;
- Ar1 et Ar2 représentent des noyaux aromatiques, identiques ou différents ;
- Ar1 et/ou Ar2 comprend au moins un substituant hydrophobe sur son noyau.

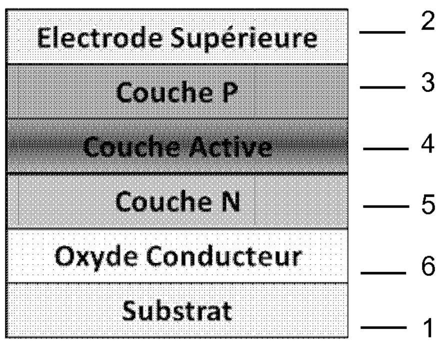


Figure 1

EP 2 763 203 A2

Printed by Jouve, 75001 PARIS (FR)

## Description

### DOMAINE TECHNIQUE

La présente invention s'inscrit dans la recherche de solutions techniques permettant de faciliter l'élaboration de dispositifs optoélectroniques, notamment des cellules photovoltaïques organiques (OPV) de type « inverse ».

Plus précisément, l'invention propose d'ajouter un additif conducteur ou semi-conducteur électrique à une formulation ou dispersion à base de PEDOT (poly(3,4-éthylènedioxythiophène) et de PSS (polystyrènesulfonate), servant en particulier à l'élaboration de la couche HTL (« *Hole Transport Layer* ») des OPVs. La présence d'un tel additif est destinée à modifier la capacité de mouillage de la formulation vis-à-vis de la surface d'une couche hydrophobe. Celle-ci peut alors être aisément déposée sous la forme d'une couche directement sur une couche hydrophobe, telle qu'une couche active en matériau semi-conducteur hydrophobe présente dans les OPVs de structure inverse. Ce dépôt peut ainsi être réalisé par des techniques classiques telles que l'impression par jet d'encre.

Cette solution peut trouver des applications aussi bien pour les OPVs que pour tout autre dispositif optoélectronique tel que les photo-détecteurs (OPD pour *« Organic Photo Detector »*), les OLEDs (« *Organic Light Emitting Diods* ») ou les PLEDs (« *Polymer Light Emitting Diods* »).

### ETAT ANTERIEUR DE LA TECHNIQUE

Les cellules photovoltaïques organiques (OPV) sont des dispositifs capables de convertir l'énergie solaire en énergie électrique grâce à l'utilisation de matériaux semiconducteurs organiques, pour produire un effet photovoltaïque. Les matériaux actifs, ainsi que les architectures de ces dispositifs, sont encore en évolution afin de répondre aux critères de performances et de durée de vie permettant d'élargir le champ d'application de ces technologies. Les procédés de fabrication de tels dispositifs restent également une préoccupation permanente.

Dans une structure classique d'OPV, un substrat **1** est recouvert des couches successives suivantes :

- une couche conductrice électrique **2** à base d'un oxyde conducteur faisant fonction de première électrode ;
- une couche **3** semi-conductrice, transporteuse de trous, aussi appelée couche HTL (pour l'acronyme anglo-saxon « *Hole Transport Layer* ») ou encore couche P ;
- une couche active **4** en matériau semi-conducteur organique ;
- une couche **5** semi-conductrice, transporteuse d'électrons, aussi appelée couche ETL (pour l'acronyme anglo-saxon « *Electron Transport Layer* ») ou encore couche N; et
- une couche conductrice **6** faisant fonction de seconde électrode.

Dans une structure inverse, également appelée structure NIP, telle que schématisée à la Figure 1, l'empilement a la séquence suivante :

- substrat **1 ;**
- une couche conductrice **6** à base d'un oxyde conducteur faisant fonction de première électrode ;
- une couche **5** semi-conductrice n (ou N) ;
- une couche active **4 ;**
- une couche **3** semi-conductrice p (ou P) ;
- une couche conductrice **2** faisant fonction de seconde électrode ou électrode supérieure.

L'un des principaux avantages de la technologie OPV est la possibilité de mettre en oeuvre les dispositifs entièrement par voie humide, *via* une gamme variée de procédés d'impression et/ou d'enduction : jet d'encre, sérigraphie, passage à travers une fente (technique dite *« slot-die »*), héliogravure, pulvérisation (ou *« spray coating »*), dépôt à la tournette ou par centrifugation (également connue sous le nom de *« spin coating »*), flexographie ou à l'aide d'une lame (technique d'enduction dite *« Doctor Blade »*)...

A ce jour, la structure dite « inverse » des OPV apparaît comme la plus prometteuse car elle permet d'atteindre les durées de vie les plus importantes. Dans cette configuration, la couche P qui est la couche transporteuse de trous ou HTL (« *Hole Transport Layer* ») est donc disposée à la surface de la couche active.

Actuellement, la couche transporteuse de trous est généralement obtenue à partir d'une formulation ou dispersion à base de PEDOT : PSS. Elle comprend :

- du Poly(3,4-EthylèneDiOxyThiophène) ou PEDOT de structure chimique :

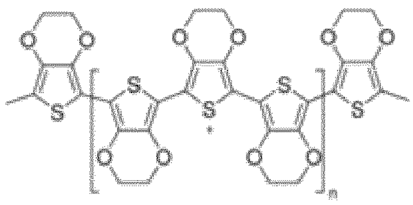

avec n un nombre entier positif

- du PolyStyrèneSulfonate ou PSS sous forme protonée (à droite) ou non (à gauche), de structure chimique :

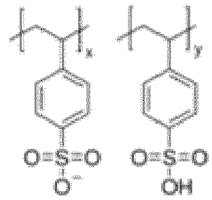

avec x et y des nombres entiers positifs.

Le PSS étant un polymère hydrosoluble, la plupart des formulations de PEDOT:PSS sont à base d'eau.

Or, dans les OPVs, la couche active sur laquelle est destinée à être déposée la formulation à base de PEDOT :PSS possède un fort caractère hydrophobe et donc une mauvaise mouillabilité vis-à-vis des formulations aqueuses.

En conséquence, la capacité de mouillage ou l'aptitude à s'étaler de la suspension de PEDOT : PSS sur la couche active est généralement mauvaise. Ainsi, il est difficile de réaliser des dépôts continus et uniformes sans recourir à des traitements de surface.

Une alternative à ces traitements consiste à adapter la formulation destinée à former la couche transporteuse de trous afin d'améliorer son caractère mouillant vis à vis de la couche active hydrophobe.

Ainsi et titre d'exemple, différentes solutions ont été envisagées pour résoudre ce problème de compatibilité entre la couche active et la couche P à base de PEDOT :PSS :

Le document Voigt et al. (Solar Energy Materials and Solar Cells, 95, 2011, 731-734) décrit l'ajout d'un solvant (isopropanol) et/ou d'un fluorosurfactant non ionique et non conducteur (Zonyl® FS300) à une formulation de PEDOT : PSS pour la mettre en oeuvre sur la couche active par héliogravure. Toutefois, les performances des OPVs ainsi obtenus sont relativement faibles et un traitement plasma de la surface est toujours nécessaire.

Le document Weickert et al. (Solar Energy Materials and Solar Cells, 95, 2010, 2371-2374) rapporte, quant à lui, la dilution de la formulation dans une grande quantité d'alcool (2-propanol) et la réalisation d'un dépôt par « spray-coating » (couchage par pulvérisation) sur la couche active. Toutefois, le taux de matière sèche étant très faible après dilution, l'épaisseur finale de la couche est faible. En relation avec la technique particulière de pulvérisation, il est possible de compenser cette faible épaisseur par la répétition des passages mais ceci n'est pas réalisable pour la majorité des techniques de dépôt. Par ailleurs, cette technique apparaît incompatible avec l'impression ultérieure d'une électrode, cet article rapportant l'évaporation de l'électrode.

Une autre option a été proposée dans le document Lloyd et al. (Solar Energy Materials and Solar Cells, 95, 2011, 1382-1388). Il s'agit de réaliser un traitement plasma sur la couche active pour la rendre plus hydrophile. Toutefois, ce traitement entraîne la création de défauts et la dégradation de cette couche.

Il apparaît donc qu'il existe un besoin évident d'identifier de nouvelles solutions techniques permettant d'améliorer la mise en oeuvre d'une couche transporteuse de trous à base de PEDOT : PSS sur la couche active hydrophobe d'un dispositif optoélectronique, et plus généralement d'une couche à base de PEDOT : PSS sur un support hydrophobe.

## OBJET DE L'INVENTION

Ainsi et dans le cadre de la présente invention, il a été identifié de nouveaux composés de type tensio-actifs, à intégrer dans des formulations ou dispersions à base de PEDOT : PSS, servant notamment à la réalisation de la

couche transporteuse de trous des OPVs, permettant à la fois :

- d'augmenter leur caractère mouillant sur une couche hydrophobe, notamment à la surface de la couche active des OPVs ;
- de ne pas affaiblir la conductivité électrique de la couche ainsi formée ;
- de rendre cette couche compatible avec l'impression d'une électrode à sa surface, dans le contexte des OPVs.

Selon un premier aspect, la présente invention concerne une composition comprenant :

- du poly(3,4-éthylènedioxythiophène) ou PEDOT ;
- du polystyrènesulfonate ou PSS ;
- un composé (A) de formule :

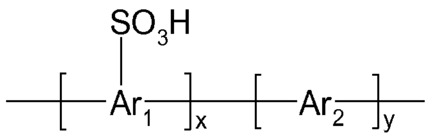

avec

· 0 < x/y < 1 ;
· Ar1 et Ar2 représentent des noyaux aromatiques, identiques ou différents ;
· Ar1 et/ou Ar2 comprend au moins un substituant hydrophobe sur son noyau.

A noter que le polystyrènesulfonate ou PSS peut être sous sa forme protonée ($SO_3H$) ou non ($SO_3^-$), ou sous les 2 formes.

Le composé (A) est donc destiné à jouer le rôle de tensio-actif dans une telle composition. Il est par ailleurs avantageusement conducteur électrique ou semi-conducteur électrique.

De par sa structure, il s'agit d'un copolymère conjugué dont un motif est substitué par un groupement sulfonique. Par ailleurs, au moins un motif du copolymère est substitué par des chaînes latérales à caractère hydrophobe.

De manière adaptée et avantageusement, le noyau aromatique Ar2 ne porte pas de groupement ionique conducteur, en particulier pas de groupement sulfonique.

Le composé (A) présente avantageusement un noyau aromatique (Ar1 et/ou Ar2) choisi dans le groupe suivant : thiophène ; bithiophène ; terthiophène ; thiénothiophène ; pyrole ; carbazole ; diketopyrrolopyrrole (DPP) ; sélénophène ; cyclopentadithiophène (CPDT) ; dithieno cyclopentadithiophène ; Si-cyclopentadithiophène (Si-CPDT) ; dithieno Si-cyclopentadithiophène ; Fluorène ; dithienofluorène ; benzène ; benzothiazole ; benzothiadazole ; dithienobenzothiadiazole ; quinoxaline ; thiazole ; phosphole, avantageusement le thiophène.

Selon un mode de réalisation privilégié, les deux noyaux aromatiques (Ar1 et Ar2) sont identiques, avantageusement des thiophènes.

Par ailleurs et de manière préférée, le substituant hydrophobe est une chaîne éther (-OR) portée par l'un des carbones du noyau aromatique. R peut être une chaîne linéaire ou ramifiée, comprenant des atomes de carbone (avantageusement de 1 à 15) et éventuellement des hétéroatomes, tels que O ou N (avantageusement de 1 à 10). De manière avantageuse, R comprend au moins une liaison éther (R'-O-R"). Encore plus avantageusement, le substituant présente la formule suivante :

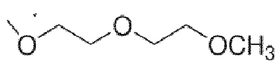

Avantageusement, un tel substituant hydrophobe est au moins porté par le noyau aromatique Ar2. Selon un mode de réalisation particulier, à la fois Ar1 et Ar2 comprennent au moins un substituant hydrophobe, le substituant hydrophobe porté par Ar1 et Ar2 étant éventuellement identique.

Selon un mode de réalisation particulier, le composé (A) présente la formule suivante :

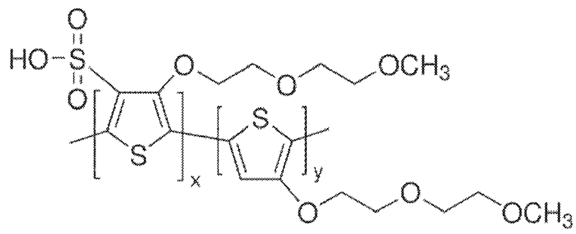

Ce composé (A) correspond au poly(3-[2-(2-methoxyethoxy)]thiophene-2,5-diyl-co-3-[2-(2-methoxyethoxy)]-4-sulfonique-thiophene-2,5-diyl). Il s'agit d'un copolymère possédant à la fois un caractère hydrophile apporté par les groupements sulfoniques ($SO_3H$) et un caractère hydrophobe apporté par les chaînes éthers. Ces groupements sont positionnés sur des groupements thiophène dont l'enchaînement permet de garantir une bonne conductivité.

A noter que ce composé est un copolymère conjugué dit « de type p », classiquement utilisé comme seul constituant de la couche HTL des cellules OPV. Il possède une bonne aptitude de mouillage sur la couche active des cellules OPV mais, du fait de sa solubilité importante, il n'est pas compatible avec les encres à base d'argent utilisées pour mettre en oeuvre l'électrode supérieure des cellules OPV. Ainsi, les dispositifs intégrant ce matériau comme couche HTL et une électrode d'argent imprimée sont systématiquement en court-circuit.

Une composition selon l'invention peut correspondre à une encre. Ainsi et de manière plus générale, elle peut, en plus de la dispersion à base de PEDOT : PSS et du composé A, comprendre au moins un solvant, avantageusement choisi dans le groupe suivant : eau ; propan-2-ol ; 2-Butoxyethanol (ou éthylèneglycolmonobutyléther, EGMBE) ; éthanol ; butan-1-ol ; butan-2-ol ; éthylène glycol ; propylène glycol ; diéthylène glycol ; dowanol DPM ; éthylène glycol méthyl éther.

Selon un mode de réalisation particulier, la composition selon l'invention comprend un mélange de propan-2-ol et de 2-butoxyéthanol, et éventuellement de l'eau. Plus précisément, elle peut contenir :

- de l'eau, avantageusement dans une proportion volumique inférieure à 5%, encore plus avantageusement inférieure à 2%, et de façon optimale égale à 0% ;
- du propan-2-ol, avantageusement dans une proportion volumique supérieure à 30%, encore plus avantageusement comprise entre 40 et 60%, et de façon optimale comprise entre 50 et 55% ;
- du 2-butoxyéthanol, avantageusement dans une proportion volumique comprise entre 10% et 50%, encore plus avantageusement comprise entre 15 et 35%.

Par ailleurs et en pratique, la dispersion à base de PEDOT : PSS, destinée à être mélangée avec le composé A et éventuellement avec un ou plusieurs des solvants cités ci-dessus, peut en outre comprendre un ou plusieurs additifs choisis dans le groupe suivant :

- un solvant à haut point d'ébullition, tel que la N-Méthyl-2-pyrrolidone ;
- un solvant tel que l'isopropanol ;
- un agent réticulant tel que le gamma-glycidoxypropyltrimethoxysilante (Silquest A187™ commercialisé par Momentive Performance Materials Inc) ;
- un agent surfactant tel qu'un additif à base de diol acétylénique, par exemple le Dynl™604 commercialisé par la société Air Product.

De manière avantageuse, le composé (A) représente de 0,01 à 0,2% en poids de la composition selon l'invention, encore plus avantageusement 0,05 à 0,2% en poids, notamment supérieure ou égale à 0, 1 % en poids.

Selon un autre aspect, la présente invention concerne un procédé de préparation d'une composition selon l'invention comprenant le mélange du composé (A) dans une dispersion à base de PEDOT :PSS, éventuellement en présence d'un ou plusieurs solvants comme définis ci-dessous et dans les proportions avantageuses mentionnés.

Dans le cadre de l'invention, une telle composition est particulièrement destinée à l'obtention d'une couche, après dépôt sur un substrat. Par exemple et comme déjà dit, la composition selon l'invention peut être une encre destinée à être déposée sur un substrat, avantageusement sur la couche active d'un dispositif optoélectronique, en particulier à l'aide de la technique d'impression par jet d'encre. Après dépôt et séchage entraînant l'évaporation du ou des solvants de la composition, la couche obtenue, avantageusement la couche transporteuse de trous d'un dispositif optoélectronique, est constituée des polymères présents dans la composition selon l'invention, en particulier du PEDOT, du PSS et du composé (A).

Ainsi et selon un autre aspect, la présente invention concerne un dispositif optoélectronique présentant une couche comprenant :

- du poly(3,4-éthylènedioxythiophène) ou PEDOT ;
- du polystyrènesulfonate ou PSS ;
- un composé (A) tel que défini ci-dessus.

Comme déjà mentionné, un tel dispositif optoélectronique peut être une cellule photovoltaïque organique (OPV), avantageusement en configuration inversée, mais également un OPD (« *Organic Photo Detector* »), une OLED (« *Organic Light Emitting Diod* ») ou une PLED (« *Polymer Light Emitting Diod* »).

De manière avantageuse, le composé (A) représente de 1 % à 30% en poids sec de ladite couche, avantageusement de 25 à 30%.

Une telle couche est avantageusement disposée à la surface de la couche active du dispositif optoélectronique. Ainsi, une telle couche a un intérêt tout particulier en tant que couche transporteuse de trous, déposée sur la couche active d'un dispositif optoélectronique tel qu'un dispositif photovoltaïque, avantageusement d'une cellule photovoltaïque organique en configuration inversée (NIP).

De manière classique, une couche active d'un dispositif optoélectronique, avantageusement photovoltaïque, combine un donneur d'électrons et un accepteur d'électrons. Ainsi et selon un mode de réalisation particulier, la couche active est constituée de :

- P3HT (poly(3-hexylthiophène-2,5-diyl) ou poly(3-hexylthiophène)) comme donneur d'électrons, de formule :

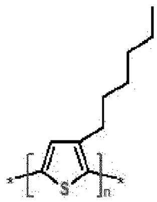

avec n nombre entier positif ;

- PCBM ou $PC_{60}BM$ ([6,6]-phényl-$C_{61}$-butyrate de méthyle) comme accepteur d'électrons, de formule :

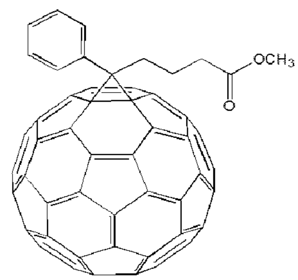

Alternativement, le polymère donneur d'électrons peut être choisi dans le groupe suivant :

- Le poly[[9-(1-octylnonyl)-9H-carbazole-2,7-diyl]-2,5-thiophenediyl-2,1,3-benzo-thiadiazole-4,7-diyl-2,5-thiophenediyl] ou PCDTBT :

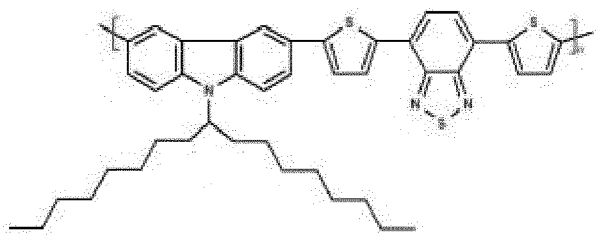

- le poly[2,1,3-benzothiadiazole-4,7-diyl[4,4-bis(2-ethylhexyl)-4H-cyclopenta[2,1-b:3,4-b']dithiophene-2,6-diyl]] ou PCPDTBT :

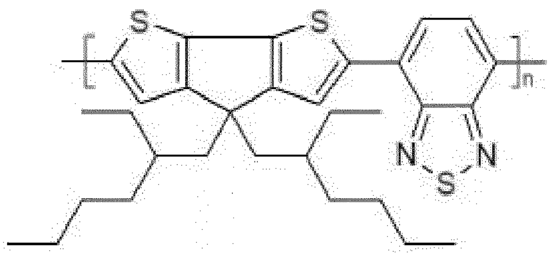

- le PBDTTPD :

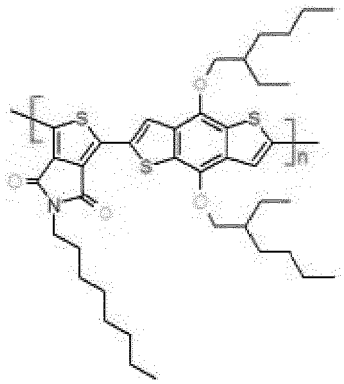

- le PTB7 :

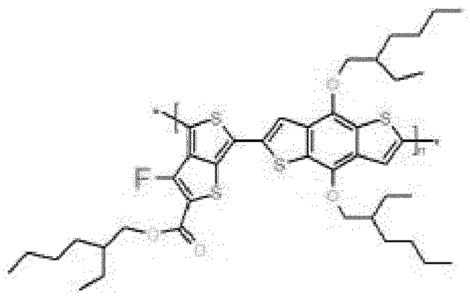

De même, l'accepteur d'électrons peut être un autre fullerène choisi dans le groupe suivant :

- le $PC_{70}BM$ ([6,6]-Phenyl C71 butyric acid methyl ester):

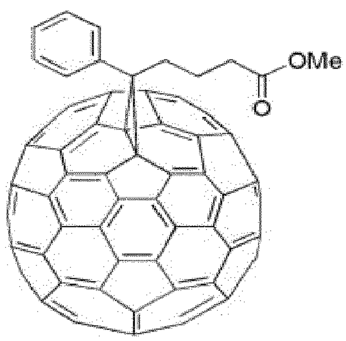

- l'$IC_{60}BA$ (1',1",4',4"-tetrahydro-di[1,4]methanonaphthaleno[5,6] fullerene-$C_{60}$):

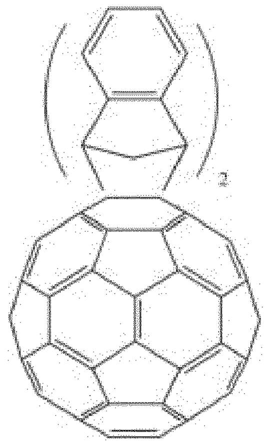

- le bis-$PC_{60}BM$ Bis(1-[3-(methoxycarbonyl)propyl]-1-phenyl)-[6.6]$C_{62}$) :

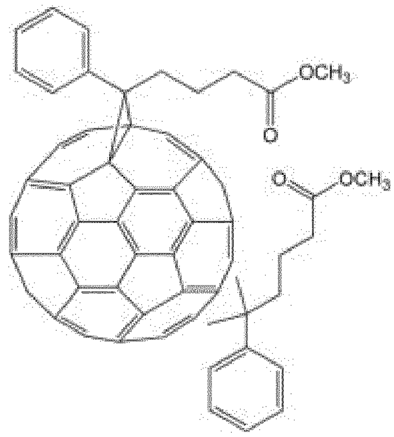

Une couche HTL selon l'invention présente la caractéristique avantageuse d'être compatible avec l'impression, à sa surface, d'une électrode. Ainsi et selon un autre aspect, le dispositif optoélectronique, avantageusement photovoltaïque, selon l'invention comprend une électrode imprimée à la surface de la couche HTL. De manière classique, celle-ci est en argent (Ag). Elle peut aussi être en cuivre, en aluminium, en graphite ou même en un mélange de ces matériaux.

Plus spécifiquement en relation avec une cellule photovoltaïque en configuration inverse, celle-ci comprend en outre :

- un substrat, avantageusement un substrat plastique, par exemple en PET (polyéthylène téréphtalate), en PEN (polyéthylène naphtalate) ou en polycarbonates ;
- une couche d'oxyde conducteur servant d'électrode, avantageusement réalisée à l'aide d'un TCO (pour l'anglicisme *« Transparent Conductive Oxide »*), par exemple de l'ITO (pour l'anglicisme « *Indium Tin Oxide* » ou *« tin-doped indium oxide »*), du GZO (pour l'anglicisme *« Gallium-doped Zinc Oxide »*), de l'AZO (à base d'aluminium), de l'YZO (à base d'Yttrium), de l'IZO (à base d'indium) ou du FTO ($SnO_2$ :F) ;
- une couche N, typiquement un oxyde métallique semi-conducteur, éventuellement dopé, tel que de l'oxyde de zinc (ZnO) éventuellement dopé à l'aluminium (Al) à l'indium (In) ou au gallium (Ga), ou du dioxyde de titane ($TiO_2$) éventuellement dopé au manganèse (Mn).

De manière remarquable selon l'invention, le procédé d'élaboration d'un dispositif optoélectronique, en particulier d'une cellule photovoltaïque en configuration inverse, peut se faire intégralement par voie humide, uniquement à l'aide de techniques de dépôt simple, aisément mises en oeuvre dans une exploitation industrielle. Ainsi et à titre d'exemple, la couche N et la couche active peuvent être déposées par « spin-coating » alors que la couche HTL et l'électrode supérieure sont déposées par impression jet d'encre.

Ainsi, la présente invention propose un procédé d'élaboration d'un dispositif optoélectronique, avantageusement d'une cellule photovoltaïque en configuration inversée (NIP), comprenant le dépôt sur une couche d'une composition telle que décrite ci-dessus, avantageusement pour former la couche HTL sur la couche active. De manière privilégiée,

ce dépôt est réalisé par impression jet d'encre.

De manière remarquable, l'ajout du composé (A) dans la formulation destinée à l'obtention de la couche HTL permet de réaliser des dépôts uniformes et homogènes sur la couche active, permettant de se passer de tout traitement de surface.

En outre, la couche HTL ainsi obtenue est compatible avec l'impression de l'électrode supérieure. Ainsi et selon un aspect particulier, ledit procédé d'élaboration comprend le dépôt ultérieur, avantageusement par impression jet d'encre, de l'électrode supérieure, par exemple en argent, à la surface de la couche HTL.

De manière plus générale, la présente invention concerne l'utilisation d'un composé (A) tel que défini ci-dessus pour augmenter la capacité de mouillage d'une composition à base de PEDOT:PSS sur une couche hydrophobe, en particulier à la surface de la couche active en matériau semi-conducteur d'un dispositif optoélectronique tel qu'une cellule photovoltaïque de structure inverse (NIP). En d'autres termes et dans ce contexte, le composé (A) de type tensio-actif est utilisé comme agent mouillant.

Les avantages de la présente invention ressortiront mieux des exemples de réalisation qui suivent.

## LEGENDES DES FIGURES

La figure 1 représente un schéma de cellules PV organiques en structure dite inverse ou NIP.

La figure 2 illustre la qualité d'éjection des gouttes à une température T=30°C d'une formulation PEDOT : PSS sans additif (A) et d'une composition selon l'invention (B).

La figure 3 illustre l'angle de goutte, sur la couche active, d'une formulation PEDOT : PSS sans additif (A) et d'une composition selon l'invention (B).

## EXEMPLES DE REALISATION

Les exemples de réalisation qui suivent, à l'appui des figures annexées, ont pour but d'illustrer l'invention mais ne sont en aucun cas limitatifs.

### 1/ Choix de l'additif :

L'additif particulier mis en oeuvre dans le cadre des exemples de réalisation présente la formule chimique suivante :

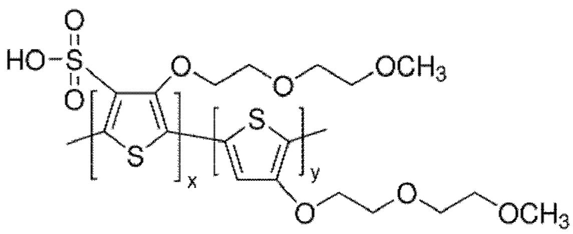

avec 0 < x/y < 1.

Il s'agit d'un copolymère possédant à la fois un caractère hydrophile apporté par les groupements sulfoniques ($SO_3H$) et un caractère hydrophobe apporté par les chaînes éthers. Ces groupements sont positionnés sur des groupements thiophène dont l'enchaînement permet de garantir une bonne conductivité. Il s'agit du poly(3-[2-(2-methoxyethoxy)]thiophene-2,5-diyl-co-3-[2-(2-methoxyethoxy)]-4-sulfonique-thiophene-2,5-diyl).

### 2/ Formulation des encres :

***a. Solutions commerciales de PEDOT : PSS***

L'effet de l'additif a été testé avec deux formulations de PEDOT : PSS commercialisées par la société Heraeus :

- CPP 105D
- F010

Les principales propriétés physico-chimiques de ces formulations sont répertoriées dans le Tableau 1 ci-dessous :

| | Taux de matière sèche (%) | Viscosité à $700s^{-1}$ (cP) | pH | Travail de sortie (eV) |
|---|---|---|---|---|
| **CPP105D** | ~ 1 | 30 | 2,8 | 4,8 |
| **F010** | ~ 1 | 30 - 60 | 2,8 | 4,8 |

***b. Solvants***

Afin d'optimiser les propriétés des encres (éjection, étalement, séchage) et l'épaisseur finale des dépôts, les solvants suivants ont été ajoutés au mélange de l'additif dans la dispersion à base de PEDOT : PSS :

- Propan-2-ol (IPA) ;
- 2-Butoxyethanol (ou éthylèneglycolmonobutyléther, EGMBE).

***c. Compositions des formulations mises en oeuvre et des films secs obtenus***

La composition des deux formulations développées est donnée dans le Tableau 2 ci-dessous, les quantités étant données en pourcentage volumique :

| | Quantité formulation PEDOT:PSS (%) | Quantité HTL Plexcore (%) | Quantité IPA (%) | Quantité EGMBE (%) |
|---|---|---|---|---|
| Encre 1 | 16 | 1 | 50 | 33 |
| Encre 2 | 25 | 5 | 55 | 15 |

HTL Plexcore : solution commerciale comprenant l'additif ;
IPA (solvant) = isopropanol ou propan-2-ol ;
EGMBE (solvant) = éthylèneglycolmonobutyléther.

Les encres sont préparées à partir de la dispersion commerciale de PEDOT: PSS (CPP 105D ou F010), à laquelle on ajoute la solution commerciale d'HTL Plexcore contenant l'additif, ainsi que de l'isopropanol, de l'EGMBE et éventuellement de l'eau.

La quantité d'HTL plexcore ajoutée est telle que la quantité d'additif dans l'encre finale est comprise entre 0,01 % et 0,2% en poids. De préférence, elle est d'au moins 0,1 % en poids.

<u>Préparation de l'encre 1 :</u>

Afin de préparer 10 mL de l'encre 1, on commence par prélever 1.6 mL de la formulation commerciale de PEDOT:PSS, à laquelle on ajoute 0.1 mL de la formulation commerciale d'HTL plexcore contenant l'additif, puis 5 mL d'isopropanol et enfin 3.3 mL d'EGMBE.

<u>Préparation de l'encre 2 :</u>

Afin de préparer 10 mL de l'encre 2, on commence par prélever 2.5mL de la formulation commerciale de

PEDOT:PSS à laquelle on ajoute 0.5 mL de la formulation commerciale d'HTL plexcore contenant l'additif, puis 5.5 mL d'isopropanol et enfin 1.5 mL d'EGMBE.

Les solutions ainsi préparées sont ensuite agitées à température et atmosphère ambiantes pendant une nuit avant leur utilisation.

La quantité d'additif dans les encres 1 et 2 est respectivement de 0,02% et 0,1% en masse.

Les proportions de PEDOT : PSS et d'additif au sein des films secs (après impression de l'encre et séchage), et donc telles que présentes au sein du dispositif final, sont également données dans le Tableau 3 ci-dessous, les valeurs correspondant à des pourcentages massiques :

| | PEDOT:PSS (%) | Additif (%) |
|---|---|---|
| Film sec Encre1 | 87,5 | 12,5 |
| Film sec Encre2 | 71,5 | 28,5 |

**3/ Impact sur la capacité d'éjection des gouttes :**

La capacité d'éjection des gouttes d'encre a été testée à l'aide d'une imprimante de matériaux de type FujiFilm Dimatix DMP 2800, avec une éjection de goutte à 30°C et en appliquant une tension de 30V.

L'encre 1 a été testée et comparée à la suspension à base de PEDOT : PSS.

Comme illustré à la Figure 2, l'ajout de l'additif permet d'améliorer la capacité d'éjection des gouttes, et notamment d'augmenter la stabilité de l'éjection des gouttes.

**4/ Impact sur l'angle de goutte :**

Les encres 1 et 2 décrites ci-dessus (avec additif), ainsi que des encres équivalentes sans additifs (correspondant à la dispersion à base de PEDOT :PSS) ont été testées.

Les essais ont été réalisés sur des échantillons de structure analogue à celle des dispositifs OPV, à savoir :

Substrat / Oxyde Conducteur / Couche N / Couche Active

La couche N est formée par conversion thermique d'un dérivé d'acétate de zinc préalablement déposé par « spin-coating ». Son épaisseur finale est d'environ 20 nm. La couche active est constituée d'un mélange de poly(3-hexylthiophène) (P3HT) et de ([6,6]-phényl-$C_{61}$-butyrate de méthyle) (PCBM). Son épaisseur sèche est de 200 nm et le ratio massique P3HT:PCBM est de 1 :0.6. Elle est déposée par « spin-coating » à partir d'une solution dans l'*ortho*-dichlorobenzène sous atmosphère inerte.

Les mesures d'angle de goutte ont été réalisées dans des conditions ambiantes de température (- 25°C) et d'humidité (- 35%), en mode statique, à l'aide d'un appareil Krüss EasyDrop DSA20 piloté par le logiciel Drop Shape Analysis II.

Chaque valeur du Tableau 4 ci-dessous correspond à la moyenne de 9 mesures.

| Formulations | | Angle de Goutte (°) |
|---|---|---|
| Encre 1 | Sans Additif | 30,5 +/- 1,6 |
| | Avec Additif | 15,2 +/- 0,9 |
| Encre 2 | Sans Additif | 40,5 +/- 3,0 |
| | Avec Additif | 23,2 +/- 1,5 |

Comme il ressort de ce tableau et de la Figure 3, la présence de l'additif au sein des formulations permet d'améliorer leur capacité à s'étaler sur la couche active des dispositifs. On note en effet une diminution nette de l'angle de goutte en présence de l'additif pour les deux formulations selon l'invention.

**<u>5/ Impact sur la conductivité du film sec :</u>**

Pour ces mesures, des dépôts d'environ 100 nm d'épaisseur ont été préparés par « spin-coating » sur des substrats verre. Les échantillons ont ensuite été recuits sur une plaque chauffante pendant 10 minutes à 120°C sous atmosphère inerte.

Comme indiqué dans le Tableau 5 ci-dessous, la présence de l'additif dans les proportions testées ne modifie pas significativement la conductivité électrique du film sec :

| Formulations | | Résistance carrée (Ω / sq) |
|---|---|---|
| Encre 1 | Sans Additif | 850 +/- 15 |
| | Avec Additif | 857 +/- 14 |
| Encre 2 | Sans Additif | 549 +/- 12 |
| | Avec Additif | 541 +/- 17 |

**<u>6/ Performance des dispositifs selon l'invention :</u>**

Les tests ont été réalisés sur des dispositifs de type NIP, possédant la structure suivante : Substrat PET (1) / Oxyde conducteur (6) / Couche N (5) / Couche Active (4) / Couche P (3) / Electrode supérieure en argent (2)
avec : Couche N (5) = Oxyde de Zinc (ZnO) ;

Couche Active (4) = poly(3-hexylthiophène) / [6,6]-phényl-$C_{61}$-butyrate de méthyle (P3HT / PCBM)

Les deux premières couches (Couche N et couche active) ont été mises en oeuvre par « spin-coating », alors que la couche P (3) et l'électrode d'argent (2) ont été mises en oeuvre par impression jet d'encre. La surface active des dispositifs était de 1,8 $cm^2$ et leurs performances ont été mesurées à 25°C dans des conditions standards d'éclairement (1000 $W/m^2$, AM 1.5G).

Le Tableau 6 ci-dessous reprend les performances des dispositifs en fonction des formulations testées :

| Formulation | Rendement |
|---|---|
| **Encre 1** | 1,20% |
| **Encre 2** | 2,10% |

Les encres 1 et 2 peuvent être mises en oeuvre par jet d'encre tout en étant compatibles avec une électrode imprimée.

Comme il ressort de ce qui précède, la présente invention préconise l'ajout d'un additif conducteur ou semi-conducteur électrique bien identifié, présentant les avantages suivants:

- permettant la réalisation de dépôts uniformes et homogènes de la couche HTL sur la couche active, sans qu'un traitement de surface ne soit nécessaire ;
- présentant des performances satisfaisantes en cellules OPV ;
- offrant une compatibilité avec une électrode imprimée.

De manière plus générale, la présente invention offre une solution technique pour formuler des compositions à base de PEDOT : PSS améliorant leur capacité de mouillage sur les surfaces hydrophobes. Ainsi, la présente invention présente des applications pour tous les dispositifs dans lesquels une couche à base PEDOT : PSS doit être déposée sur une couche hydrophobe, en particulier sur la couche active en matériau semi-conducteur hydrophobe d'un dispositif optoélectronique, tel que les OLEDs et les PLEDs.

## Revendications

1. Composition comprenant :

   - du poly(3,4-éthylènedioxythiophène) ou PEDOT ;
   - du polystyrènesulfonate ou PSS ;
   - un composé (A) de formule :

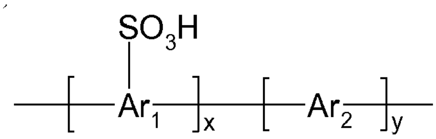

   avec

   - 0 < x/y < 1 ;
   - Ar1 et Ar2 représentent des noyaux aromatiques, identiques ou différents ;
   - Ar1 et/ou Ar2 comprend au moins un substituant hydrophobe sur son noyau.

2. Composition selon la revendication 1 ***caractérisée* en ce que** le composé (A) est conducteur électrique ou semi-conducteur électrique.

3. Composition selon la revendication 1 ou 2 ***caractérisée* en ce que** les noyaux aromatiques (Ar1, Ar2) sont choisis dans le groupe suivant : thiophène ; bithiophène ; terthiophène ; thiénothiophène ; pyrole ; carbazole ; diketopyrrolopyrrole (DPP) ; sélénophène ; cyclopentadithiophène (CPDT) ; dithieno cyclopentadithiophène ; Si-cyclopentadithiophène (Si-CPDT) ; dithieno Si-cyclopentadithiophène ; Fluorène ; dithienofluorène ; benzène ; benzothiazole ; benzothiadazole ; dithienobenzothiadiazole ; quinoxaline ; thiazole ; phosphole.

4. Composition selon la revendication 3 ***caractérisée* en ce que** les noyaux aromatiques Ar1 et Ar2 sont des thiophènes.

5. Composition selon l'une des revendications précédentes ***caractérisée* en ce que** le substituant hydrophobe est une chaîne éther (-O-R), R pouvant être une chaîne linéaire ou ramifiée, comprenant des atomes de carbone, avantageusement de 1 à 15, et éventuellement des hétéroatomes, tels que O ou N, avantageusement de 1 à 10.

**6.** Composition selon la revendication 5 ***caractérisée* en ce que** Ar1 et/ou Ar2, avantageusement Ar1 et Ar2, comprennent un substituant hydrophobe de structure :

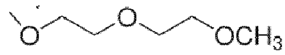

**7.** Composition selon l'une des revendications précédentes ***caractérisée* en ce que** le composé (A) présente la formule suivante :

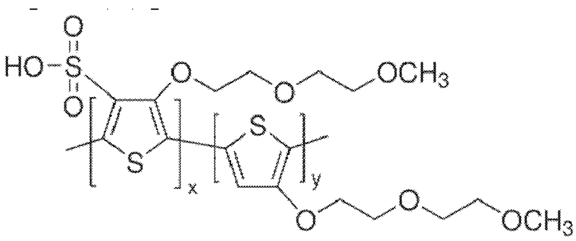

**8.** Composition selon l'une des revendications précédentes ***caractérisée* en ce qu'**elle comprend en outre au moins un solvant choisi dans le groupe suivant : eau ; propan-2-ol ; 2-Butoxyethanol (ou éthylèneglycolmonobutyléther, EGMBE) ; éthanol ; butan-1-ol ; butan-2-ol ; éthylène glycol ; propylène glycol ; diéthylène glycol ; dowanol DPM ; éthylène glycol méthyl éther.

**9.** Composition selon la revendication 8 ***caractérisée* en ce qu'**elle comprend :

- de l'eau, avantageusement dans une proportion volumique inférieure à 5%, encore plus avantageusement inférieure à 2%, et de façon optimale égale à 0% ;
- du propan-2-ol, avantageusement dans une proportion volumique supérieure à 30%, encore plus avantageusement comprise entre 40 et 60%, et de façon optimale comprise entre 50 et 55% ;
- du 2-butoxyéthanol, avantageusement dans une proportion volumique comprise entre 10% et 50%, encore plus avantageusement comprise entre 15 et 35%.

**10.** Composition selon l'une des revendications précédentes ***caractérisée* en ce que** le composé (A) représente de 0,05 à 0,2% en poids de la composition.

**11.** Procédé de préparation d'une composition selon l'une des revendications 1 à 10 comprenant le mélange du composé (A) dans une dispersion à base de PEDOT :PSS.

**12.** Procédé d'élaboration d'un dispositif optoélectronique, avantageusement d'une cellule photovoltaïque (OPV) en configuration inversée (NIP), comprenant le dépôt sur une couche d'une composition selon l'une des revendications 1 à 10, avantageusement pour former la couche HTL sur la couche active.

**13.** Procédé d'élaboration d'un dispositif optoélectronique selon la revendication 12 ***caractérisé* en ce que** le dépôt est réalisé par impression jet d'encre.

**14.** Procédé d'élaboration d'un dispositif photovoltaïque selon la revendication 12 ou 13 ***caractérisé* en ce que** l'électrode supérieure, par exemple en argent, est ensuite déposée à la surface de la couche HTL avantageusement par impression jet d'encre.

**15.** Dispositif optoélectronique, avantageusement cellule photovoltaïque en configuration inversée (NIP), présentant une couche comprenant :

- du poly(3,4-éthylènedioxythiophène) ou PEDOT ;
- du polystyrènesulfonate ou PSS ;
- un composé (A) tel que défini dans l'une des revendications 1 à 7.

**16.** Dispositif optoélectronique selon la revendication 15 ***caractérisé* en ce que** le composé (A) représente de 1% à

30% en poids sec de ladite couche, avantageusement de 25 à 30%.

**17.** Dispositif optoélectronique selon la revendication 15 ou 16 ***caractérisé* en ce que** ladite couche est disposée à la surface de la couche active du dispositif.

**18.** Utilisation d'un composé (A) tel que défini dans l'une des revendications 1 à 7 pour augmenter la capacité de mouillage d'une composition à base de PEDOT :PSS sur une couche, avantageusement sur la couche active d'un dispositif optoélectronique.

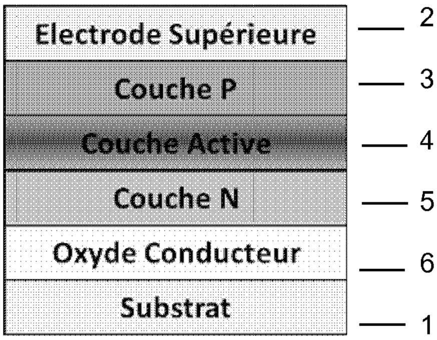


Figure 1

A/

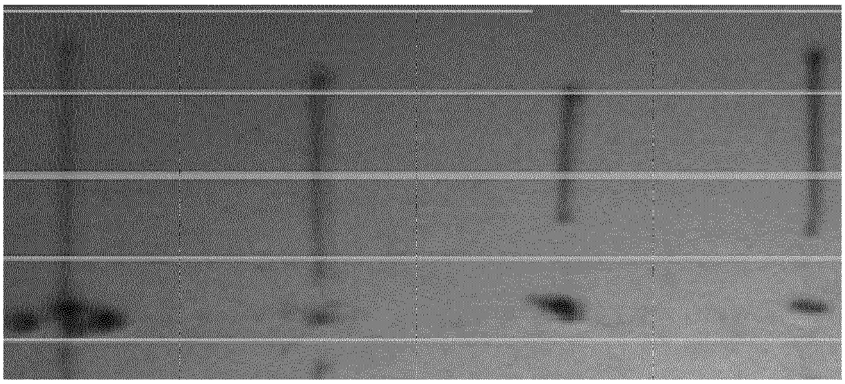

B/

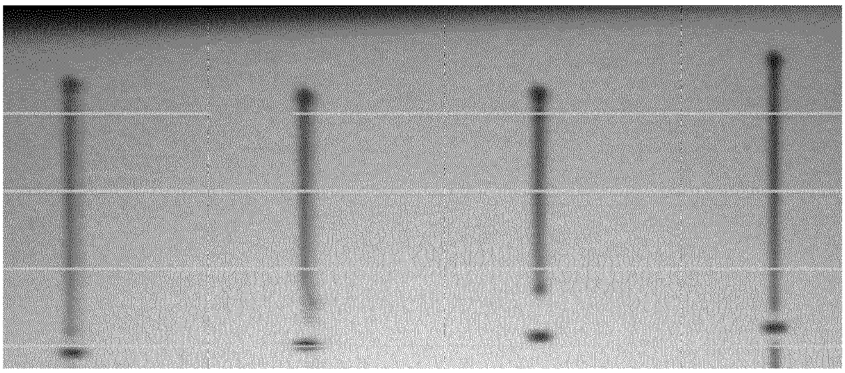

Figure 2

A/

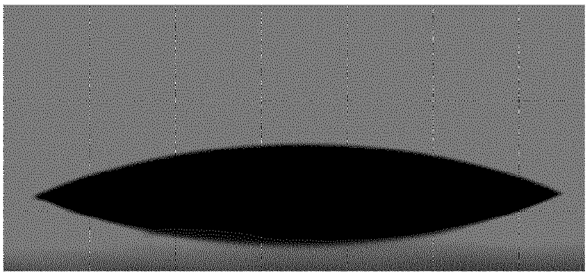

B/

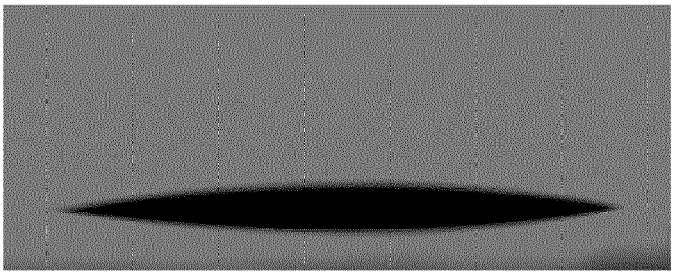

Figure 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description


- **VOIGT et al.** *Solar Energy Materials and Solar Cells,* 2011, vol. 95, 731-734
- **WEICKERT et al.** *Solar Energy Materials and Solar Cells,* 2010, vol. 95, 2371-2374
- **LLOYD et al.** *Solar Energy Materials and Solar Cells,* 2011, vol. 95, 1382-1388